# EUROPEAN PATENT SPECIFICATION

(11) **EP 2 071 349 B1**
(45) Date of publication and mention of the grant of the patent: **09.01.2013**
(21) Application number: 07713901.2
(22) Date of filing: 07.02.2007
(51) Int. Cl.: G01R 33/09, G01R 33/00

(54) **MAGNETISM DETECTOR AND ITS MANUFACTURING METHOD**
MAGNETISMUSDETEKTOR UND VERFAHREN ZU SEINER HERSTELLUNG
DÉTECTEUR DE MAGNÉTISME ET SON PROCÉDÉ DE FABRICATION

(30) Priority: 30.08.2006 JP 2006234404
(43) Date of publication of application: 17.06.2009
(73) Proprietor: Alps Electric Co., Ltd., Tokyo 145-8501 (JP)
(72) Inventor: SASAKI, Yoshito, Tokyo 145-8501 (JP); SASAKI, Shinichi, Tokyo 145-8501 (JP); HIRAYAMA, Motoki, Tokyo 145-8501 (JP); ANDO, Hideto, Tokyo 145-8501 (JP); AOKI, Daigo, Tokyo 145-8501 (JP)
(74) Representative: Klunker . Schmitt-Nilson . Hirsch
(86) International application number: PCT/JP2007/052103
(87) International publication number: WO 2008/026328

(56) References cited:
- JP-A- 03 175 634
- JP-A- 04 265 819
- JP-A- 10 268 011
- JP-A- 62 293 763
- JP-A- 2002 277 281
- JP-A- 2003 315 432
- US-A- 5 038 130
- US-A1- 2003 197 503

## Description

### Technical Field

The present invention relates to a magnetic detection device having a magnetic detection element which detects an external magnetic field using an anisotropic magnetoresistance effect (AMR effect), a giant magnetoresistance effect (GMR effect), or a tunnel magnetoresistance effect (TMR effect), and a detection circuit which detects an electrical resistance of the detection element.

### Background Art

Magnetic detection devices which detect external magnetic fields are used as ON-OFF switches of non-contact type and rotary encoders which detect the phase of rotation or the number or rotations. Most of conventional magnetic detection devices of this type use Hall elements as magnetic detection elements. However, a magnetic detection device using a Hall element needs a correction circuit for correcting detection output, and thus the circuit configuration of a detection circuit is complicated, which is a drawback. In that respect, a magnetic detection element using a magnetoresistance effect is advantageous in that the circuit configuration of a detection circuit can be relatively simplified, and moreover an external magnetic field can be detected with high precision.

A magnetic detection device includes a detection circuit disposed on a substrate, and a magnetic detection element disposed on the detection circuit with an insulating layer therebetween. The magnetic detection element and an interconnection layer constituting the magnetic circuit are electrically connected to each other through a hole formed in the insulating layer.

In a semiconductor device, as shown in Patent Document 1, for example, in Fig. 2, etc., aluminum interconnections and functional elements, such as ICs, disposed on a substrate are protected by covering them with an insulating protection layer (passivation film). Formation of the protection layer is generally performed to isolate and protect the device from an external environment and to mechanically and chemically protect the device.
Patent Document 1: Japanese Unexamined Patent Application Publication No. 7-45616
Patent Document 2: Japanese Unexamined Patent Application Publication No. 4-257238

US 2003/197503 A1 discloses a magnetoresistive sensor device including a substrate, and a sensing portion and a signal processing circuit formed above the substrate with a resin film being disposed between the sensing portion and the signal processing circuit, characterized in that the sensing portion detects changes in a magnetic field induced by a moving body and further the sensing portion is located at a position for effectively detecting changes in a magnetic field induced by the moving body, the sensing portion is constituted by a magnetoresistive sensor element.

US 5 038 130 A discloses a system for sensing changes in a magnetic field, comprising: a plurality of resistor elements each formed from the same type of magnetoresistor (MR) material, at least one of said resistor elements including an additional structure which substantially increases its magnetoresistance compared to a resistor element of said MR material without said additional structure, and output means interconnected with said resistor elements to produce an output which varies in accordance with changes in the magnetic field strength at said resistor elements which include said additional structure.

### Disclosure of Invention

### Problems to be Solved by the Invention

However, the surface of the protection layer is a stepped surface, and when a magnetic detection element is formed on the protection layer, it is not possible to form the magnetic detection element with high precision. Accordingly, in Patent Document 1, the stepped surface formed on the protection layer is covered with a plasma oxide layer, and then the surface of the plasma oxide layer is subjected to grinding treatment. Such a method complicates the manufacturing process, which is undesirable.

When a resist layer is used as a material that covers the stepped surface of the protection layer, the grinding treatment, etc. is not required, and a surface almost similar to a planarized surface can be obtained. However, a formation area of the resist layer gives rise to a problem. That is, depending on the formation area of the resist layer, cracks and disconnections may occur in the magnetic detection element formed on the resist layer and an electrode layer, etc. connected thereto, or the resist layer may become separated. As a result, it is not possible to manufacture a magnetic detection device having stable characteristics.

The present invention solves the conventional problems described above. It is an object of the present invention to provide a magnetic detection element having stable characteristics in which, in particular, the formation area of a resist layer that covers an insulation protection layer is adjusted so that a magnetic detection element and a connection layer can be formed with high precision on a surface having small steps and the resist layer can be prevented from being separated, and to provide a method of manufacturing the same.

### Means for Solving the Problems

A magnetic detection device according to the present invention includes a magnetic detection element using a magnetoresistance effect in which an electrical resistance varies in response to an external magnetic field, and a detection circuit which detects a variation in the electrical resistance of the magnetic detection element, the detection circuit having an interconnection layer and being disposed on a substrate. The detection circuit and the substrate are covered with an insulating layer. The insulating layer includes an insulation protection layer extending over from the detection circuit to the substrate and having a hole extending from a portion of the interconnection layer, and a resist layer overlapping the insulation protection layer and having a hole at a position facing the hole formed in the insulation protection layer in a layer thickness direction, thereby eliminating a step on the surface of the insulation protection layer resulting from the level difference between the substrate and the detection circuit. The resist layer extends onto the interconnection layer through the insulation protection layer and a lower edge portion of a hole formation surface of the resist layer is disposed on the insulation protection layer so that the resist layer is not directly in contact with an upper surface of the interconnection layer. The magnetic detection element is disposed on the surface of the insulating layer, a conductive connection layer connected to the magnetic detection element passes through the hole and extends to an exposed surface of the interconnection layer, and the magnetic detection element and the interconnection layer are conductively connected to each other through the connection layer.

In the present invention, by disposing a resist layer so as to overlap the insulation protection layer, it is possible to obtain a surface almost similar to a planarized surface in the insulating layer. The resist layer extends onto the interconnection layer, and the lower edge portion of the hole formation surface of the resist layer is adjusted so that the resist layer is not directly in contact with the interconnection layer exposed at the hole. Consequently, in the present invention, the magnetic detection element and the connection layer can be formed on the insulating surface having small steps, and the resist layer can be prevented from being separated. Thereby, it is possible to obtain a magnetic detection device having stable characteristics.

In the present invention, preferably, the hole formation surface of the resist layer is an inclined surface which is inclined such that the size of the hole gradually increases from a lower surface side toward an upper surface side.

Furthermore, preferably, a hole formation surface of the insulation protection layer is an inclined surface which is inclined such that the size of the hole gradually increases from a lower surface side toward an upper surface side.

Since the inclined surface is formed as described above, the connection layer can be formed on the gently inclined surface, and the magnetic detection element and the interconnection layer can be appropriately and easily connected to each other electrically.

In the present invention, preferably, the insulation protection layer is composed of any one of SiN, SiO₂, Al₂O₃, TEOS, and Ta₂O₅, or a layered structure including any two or more of them. In particular, more preferably, the insulation protection layer is composed of SiN. Thereby, the detection circuit can be appropriately protected mechanically and chemically in a manufacturing process, and the detection circuit can also be protected from an external environment, etc. after the manufacturing process.

In the present invention, preferably, the interconnection layer is composed of any one of Al, Cu, Al-Si, Al-Si-Cu, Cr, Ta, W, Au, Ag-Pd, and Ag-Pt-Pd, or a layered structure including any two or more of them. In particular, more preferably, the interconnection layer is composed of Al. Thereby, the resistance of the interconnection layer can be decreased, and the interconnection layer is suitable for use in wire bonding or the like. In the present invention, even if the interconnection layer is composed of the material described above, since the resist layer is not directly formed on the interconnection layer, the resist layer can be appropriately prevented from being separated.

In the present invention, a structure may be employed in which a fixed resistance element which is connected in series to the magnetic detection element and in which an electrical resistance does not vary in response to an external magnetic field is disposed on a surface of the insulating layer, and a connection layer provided between the magnetic detection element and the fixed resistance element is conductively connected to the interconnection layer through the hole.

In the present invention, preferably, the fixed resistance element is composed of the same material layer as the magnetic detection element. Thereby, it is possible to prevent the variation in temperature coefficient (TCR) between the magnetic detection element and the fixed resistance element.

Furthermore, there is provided a method of manufacturing a magnetic detection device according to the present invention, the magnetic detection device including a magnetic detection element using a magnetoresistance effect in which an electrical resistance varies in response to an external magnetic field, and a detection circuit which detects a variation in the electrical resistance of the magnetic detection element, the method including the steps of (a) forming the detection circuit on a substrate; (b) forming an insulation protection layer by sputtering or CVD chemical vapor deposition (VCD) so as to extend over from the detection circuit to the substrate, and forming a hole in the insulation protection layer so that a portion of an interconnection layer constituting the detection circuit is exposed; (c) applying a resist layer onto the insulation protection layer so as to at least reduce the level difference between the substrate and the detection circuit covered with the insulation protection layer, forming a hole in the resist layer, the hole overlying the hole formed in the insulation protection layer in a layer thickness direction on the interconnection layer, and disposing a lower edge portion of a hole formation surface of the resist layer on the insulation protection layer so that the resist layer is not directly in contact with an upper surface of the interconnection layer; and (d) forming the magnetic detection element on the insulating surface, forming a conductive connection layer connected to the magnetic detection element so as to extend through the hole to an exposed surface of the interconnecting layer, and conductively connecting the magnetic detection element and the interconnection layer to each other through the connection layer.

Consequently, in the present invention, the magnetic detection element and the connection layer can be formed on the insulating surface having small steps. Furthermore, since the position of the lower edge portion of the hole formation surface of the resist layer is adjusted so that the resist layer is not directly in contact with the interconnection layer exposed at the hole, the problem of separation of the resist layer does not occur. Therefore, disconnections and the like do not occur, and it is possible to manufacture a magnetic detection device excellent in electrical stability, etc. compared with the conventional art.

In the present invention, in the step (b), preferably, a hole formation surface of the insulation protection layer is formed into an inclined surface so that the size of the hole gradually increases from a lower surface side toward an upper surface side.

Furthermore, in the step (c), preferably, a hole formation surface of the resist layer is formed into an inclined surface so that the size of the hole gradually increases from a lower surface side toward an upper surface side. In this step, more preferably, the resist layer is subjected to heat treatment to form the inclined surface before the resist layer is thermally cured.

Since the inclined surface is formed as described above, the connection layer can be formed on the gently inclined surface, and the magnetic detection element and the interconnection layer can be appropriately and easily connected to each other electrically through the connection layer.

Furthermore, in the present invention, without forming a hole in the insulation protection layer in the step (b), using the resist layer formed in the step (c) as a mask, the insulation protection layer exposed at the hole of the resist layer may be removed, thereby forming a hole in the insulation protection layer in which an upper surface of the interconnection layer is exposed, which is preferable because the manufacturing process can be simplified.

Furthermore, in the present invention, the method may include, between the step (c) and the step (d), the step of (e) forming an inorganic insulating layer, as an underlying film of the magnetic detection element, on the resist layer, which is preferable because the magnetic detection element can be appropriately formed.

### Advantages

In the present invention, by disposing a resist layer so as to overlap the insulation protection layer, it is possible to obtain a surface almost similar to a planarized surface in the insulating layer. The resist layer is formed so as to extend above the interconnection layer, and the lower edge portion of the hole formation surface of the resist layer is adjusted so that the resist layer is not directly in contact with the interconnection layer exposed at the hole. Consequently, in the present invention, the magnetic detection element and the connection layer can be formed on the insulating surface having small steps, and the resist layer can be prevented from being separated. Thereby, it is possible to obtain a magnetic detection device having stable characteristics.

### Best Modes for Carrying Out the Invention

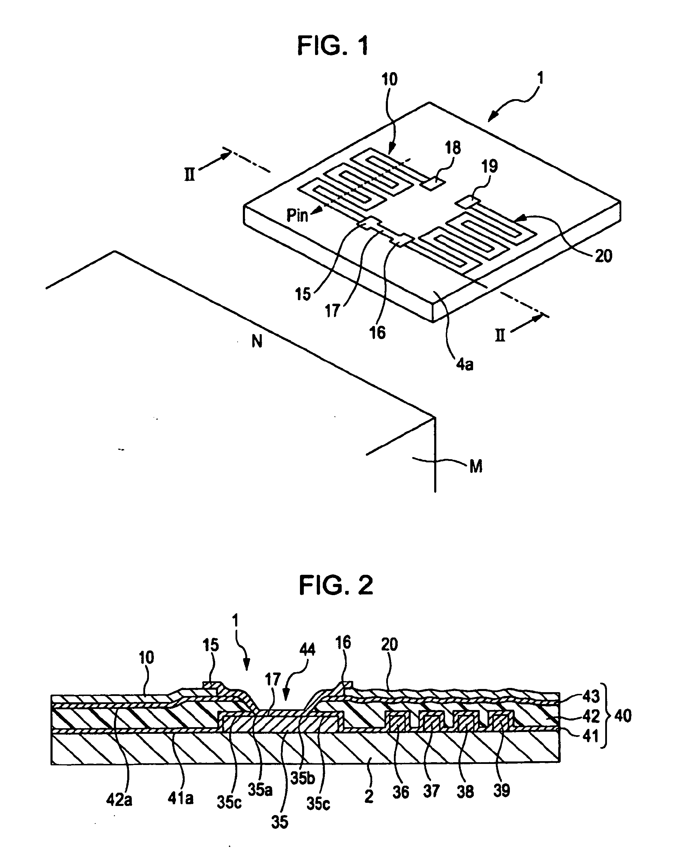

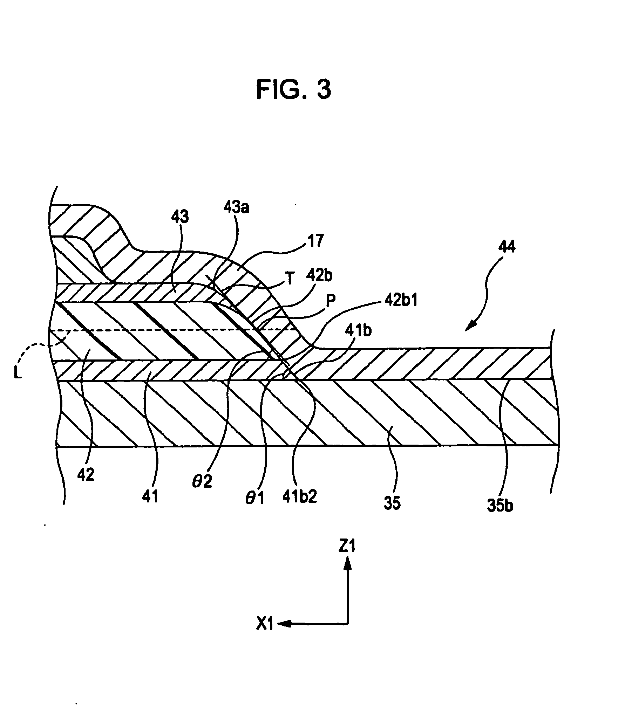

Fig. 1 is a perspective view showing a magnetic detection device according to an embodiment of the present invention. Fig. 2 is a longitudinal cross-sectional view of the magnetic detection device taken along the line II-II of Fig. 1. Fig. 3 is an enlarged longitudinal cross-sectional view showing a part of Fig. 2.

A magnetic detection device 1 shown in Fig. 1 is an IC package in which a magnetic detection element 10, a fixed resistance element 20, and a detection circuit are integrated, and is configured to be small and thin.

The magnetic detection device 1, for example, may generate a pulsed ON output when a magnetic field-generating member, such as a magnet M, is brought close to the magnetic detection device 1. For example, the magnetic detection device 1 is built in a main body portion in which a key switch is arranged in a foldable cellular phone. A magnet M is mounted on a foldable portion having a display device, such as a liquid crystal device. When the main body portion and the foldable portion are folded, the magnet M is brought close to the magnetic detection device 1, and a magnetic field generated from the magnet M is detected by the magnetic detection device 1. Thereby, an ON output is generated from the magnetic detection device 1.

The place where the magnetic detection device 1 is installed is not limited to the cellular phone. For example, the magnetic detection device 1 may be installed in an automobile and used in a seat position detection portion, a seat belt fastening detection portion, etc. The magnetic detection device 1 can also be used for detecting the phase of rotation or the number of rotations of a rotary magnet by changing the circuit configuration.

The magnetic detection element 10 uses a magnetoresistance effect in which an electrical resistance varies in response to an external magnetic field. The fixed resistance element 20 has substantially the same electrical resistance and the same temperature coefficient as the magnetic detection element 10. The electrical resistance of the fixed resistance element 20 does not substantially vary when an external magnetic field having the magnitude at which the magnetic detection element 10 responses is applied.

The magnetic detection element 10 detects an external magnetic field using a giant magnetoresistance effect (GMR effect). The magnetic detection element 10 has a basic stack structure of antiferromagnetic layer/fixed magnetic layer/non-magnetic layer/free magnetic layer. The antiferromagnetic layer is composed of an Ir-Mn alloy (iridium-manganese alloy), a Pt-Mn alloy (platinum-manganese alloy), or the like. Each of the fixed magnetic layer and the free magnetic layer is composed of a Co-Fe alloy (cobalt-iron alloy), a Ni-Fe alloy (nickel-iron alloy), or the like. The non-magnetic layer is composed of a non-magnetic conductive material, such as Cu (copper). The magnetic detection element 10 may further include a protective layer, an underlying layer, etc.

The fixed resistance element 20 is preferably composed of the same material layer as the magnetic detection element 10. That is, the fixed resistance element 20 also includes an antiferromagnetic layer, a fixed magnetic layer, a non-magnetic layer, and a free magnetic layer which are composed of the same materials as the magnetic detection element 10. However, the stacking order in the fixed resistance element 20 is different from that in the magnetic detection element 10. The fixed resistance element 20 has, for example, a structure of antiferromagnetic layer/fixed magnetic layer/free magnetic layer/non-magnetic layer stacked in that order from the bottom (or in the reversed order). The free magnetic layer constituting the fixed resistance element 20 is a magnetic layer in which the magnetization direction is fixed, as in the fixed magnetic layer, and the resistance does not vary even if an external magnetic field varies (i.e., is not anymore a free magnetic layer). Most suitably, the individual layers constituting the fixed resistance element 20 are composed of the same materials with the same thicknesses as the corresponding layers constituting the magnetic detection element 10 in view of suppressing a variation in the temperature coefficient (TCR).

The magnetic detection element 10 may be, besides a GMR element, also an AMR element using an anisotropic magnetoresistance effect or a TMR element using a tunnel magnetoresistance effect.

As shown in Fig. 1, the planar shape of each of the magnetic detection element 10 and the fixed resistance element 20 is formed in a meander pattern, and the basic electrical resistance thereof is high. By forming the meander pattern, the current consumption can be reduced. In the fixed magnetic layer constituting the magnetic detection element 10, the magnetization direction is fixed in a Pin direction shown in Fig. 1 by antiferromagnetic coupling of the antiferromagnetic layer. That is, the magnetization is fixed in a direction perpendicular to a longitudinal direction of the magnetic detection element 10. Consequently, as shown in Fig. 1, for example, when the north pole of the magnet M is brought close to the magnetic detection device 1 and the free magnetic layer constituting the magnetic detection element 10 is magnetized in a direction opposite the Pin direction, the electrical resistance of the magnetic detection element 10 is at a maximum. When the magnet M is distanced from the magnetic detection device 1 and the external magnetization applied to the free magnetic layer is removed, the resistance of the magnetic detection element 10 is at a minimum.

As shown in Fig. 1, one end of the magnetic detection element 10 is provided with an electrode layer (connection layer) 15 composed of a low-resistance material, and the other end is provided with an electrode layer (connection layer) 18 also composed of a low-resistance material. One end of the fixed resistance element 20 is provided with an electrode layer (connection layer) 16 composed of a low-resistance material, and the other end is also provided with an electrode layer (connection layer) 19 composed of a low-resistance material. The electrode layer 15 of the magnetic detection element 10 and the electrode layer 16 of the fixed resistance element 20 are connected to each other by a lead layer (connection layer) 17, and the magnetic detection element 10 and the fixed resistance element 20 are connected in series. The electrode layers and the lead layer are each mainly composed of a low-resistance material, such as gold, silver, or copper, and, for example, composed of a stacked structure of chromium/copper/chromium. The electrode layers 15 and 16 and the lead layer 17 are integrally formed.

One of the electrode layers 18 and 19 is an input terminal, and the other is a ground terminal. The lead layer 17 is an output terminal. When an external magnetic field does not act on the device, the potential of the output terminal is a neutral potential. When the external magnetic field acts on the device, the resistance of the magnetic detection element 10 varies, resulting in a variation in the potential in the lead layer 17. In the detection circuit connected to the lead layer 17, the potential variation due to the variation in the electrical resistance of the magnetic detection element 10 in response to the external magnetic field is detected, and an ON-OFF switching signal is generated on the basis of the detection result.

As shown in Fig. 2, in the magnetic detection device 1, for example, an underlying film (not shown) composed of silicon dioxide (SiO₂) is disposed with a certain thickness on a substrate 2 composed of silicon (Si).

An interconnection layer 35, active elements 36 to 38, a resistor 39, etc., constituting the detection circuit are disposed on the underlying film. The active elements 36 to 38 are an IC, a differential amplifier, a comparator, an output transistor, and the like.

The interconnection layer 35 is preferably composed of any one of Al, Cu, Al-Si, Al-Si-Cu, Cr, Ta, W, Au, Ag-Pd, and Ag-Pt-Pd, or a layered structure including any two or more of them. More preferably, the interconnection layer 35 is composed of aluminum (Al). Thereby, the resistance of the interconnection layer 35 can be decreased, and wire bonding or the like (not shown) can be performed appropriately.

Although an upper surface 35a of the interconnection layer 35 is a planarized surface, an exposed surface 35b of the interconnection layer 35 exposed at a hole portion 44 formed in an insulating layer 40, which will be described below, may be a recessed surface that is lower than a peripheral surface 35c around the exposed surface 35b.

As shown in Fig. 2, the insulating layer 40 is disposed over from the interconnection layer 35 to the active elements 35 to 39, the resistor 39, and the substrate 2, the insulating layer 40 having a structure in which an insulation protection layer 41, a resist layer 42, and an insulating coating layer 43 are disposed in that order from the bottom.

In the insulating layer 40, the hole portion 44 is formed on a part of the interconnection layer 35, and the upper surface 35a of the interconnection layer 35 is exposed at the hole portion 44. The planar shape of the hole portion 44 may be circular, rectangular, or the like although not particularly limited thereto.

As shown in Fig. 2, the insulation protection layer 41 (passivation film) is disposed over the entire region of the interconnection layer 35, the active elements 36 to 38, the resistor 39, and the substrate 2 excluding the hole portion 44. The insulation protection layer 41 is formed, for example, by sputtering or CVD, and preferably, is composed of any one of SiN, SiO₂, Al₂O₃, TEOS (tetraethoxysilane), and Ta₂O₅, or a layered structure including any two or more of them. More preferably, the insulation protection layer 41 is composed of silicon nitride (SiN). Thereby, the interconnection layer 35, the active elements 36 to 38, and the resistor 39 can be appropriately insulated and protected. In addition, the insulation protection layer 41 serves as a bonding layer that improves, in particular, adhesiveness between the resist layer 42 and the interconnection layer 35. The average thickness of the insulation protection layer 41 which is formed by sputtering is small at about 0.5 µm. On the other hand, the thickness of the interconnection layer 35, the active elements 36 to 38, etc. is about 0.1 to 1.5 µm. A surface 41a of the insulation protection layer 41 is a precipitous stepped surface due to a stepped portion between the interconnection layer 35 and the substrate 2, the stepped portion by the active elements 36 to 38 and the substrate 2, etc.

In this embodiment, the resist layer (planarizing resist) 42 is disposed on the insulation protection layer 41. In a recessed portion formed in the surface 41a of the insulation protection layer 41, the resist layer 42 is filled. The surface 42a of the resist layer 42 is closer to the planarized surface than the surface 41a of the insulation protection layer 41. In particular, although the surface 41a of the insulation protection layer 41 has a high degree of planarization as in the surface 42a of the resist layer 42 in an area where the detection circuit is not disposed, the surface 41a of the insulation protection layer 41 has a lower degree of planarization than the surface 42a of the resist layer 42 in an area where the detection circuit is disposed. By overlying the resist layer on the insulation protection layer, at least the stepped portion between the substrate and the detection circuit can be reduced compared with the insulation protection layer 41. Overall, the surface 42a of the resist layer 42 is closer to the planarized surface than the surface 41a of the insulation protection layer 41.

The resist layer 42 is provided in order to secure higher insulation properties and to bring the insulating surface closer to the planarized surface. The degree of planarization can be determined, for example, using the centerline average roughness (Ra) as an index. The average thickness of the resist layer 42 on the interconnection layer 35 is about 0.5 to 1.0 µm.

The insulating coating layer (inorganic insulating layer) 43 is disposed on the resist layer 42, the insulating coating layer being composed of any one of silicon nitride (SiN), silicon dioxide (SiO₂), and alumina (Al₂O₃), or a layered structure including any two or more of them. By providing the insulating coating layer 43, insulating properties can be secured more reliably. Furthermore, the insulating coating layer 43 composed of the inorganic insulating layer is most suitable as the underlying layer of the magnetic detection element 10, which is formed on the insulating layer 40. Note that, formation of the insulating coating layer 43 is not essential.

As shown in Fig. 2, the resist layer 42 is disposed, through the insulation protection layer 41, over the entire region of the interconnection layer 35, the active elements 36 to 38, the resistor 39, and the substrate 2 excluding the recessed portion 44.

In this embodiment, as shown in Fig. 3, a lower edge portion 42b1 of a hole formation surface 42b of the resist layer 42 is provided on the insulation protection layer 41 at a position more away (in the X1 direction in the drawing) from an exposed surface 35b of the interconnection layer 35 than a lower edge portion 41b1 of a hole formation surface 41b of the insulation protection layer 41. That is, the resist layer 42 does not extend to the exposed surface 35b of the interconnection layer 35, and the resist layer 42 and the interconnection layer 35 are not directly in contact with each other.

As shown in Figs. 2 and 3, the magnetic detection element 10 and the fixed resistance element 20 are formed on the insulating coating layer 43 which is formed on the resist layer 42. Each of the electrode layers 15, 16, 18, and 19 is formed on the corresponding end of the magnetic detection element 10 and the fixed resistance element 20. As shown in Figs. 2 to 3, the lead layer 17 which connects the electrode layer 15 of the magnetic detection element 10 and the electrode 16 of the fixed resistance element 20 to each other is formed over a hole formation surface 43a of the insulating coating layer 43, the hole formation surface 42b of the resist layer 42, the hole formation surface 41b of the insulation protection layer 41, and the exposed surface 35b of the interconnection layer 35 in the hole portion 44. Thereby, the magnetic detection element 10 and the fixed resistance element 20 are electrically connected to the interconnection layer 35 through the electrode layers 15 and 16 and the lead layer 17.

A hole portion 44 formed in the insulating layer 40 is also formed in the electrode layer 18 of the magnetic detection element 10 and in the electrode layer 19 of the fixed resistance element 20 at an opposed position. The hole portion 44 has the same cross-sectional shape as that shown in Fig. 3. The magnetic detection element 10 is electrically connected to an interconnection layer (not shown) through the electrode layer 18, and the fixed resistance element 20 is electrically connected to an interconnection layer (not shown) through the electrode layer 19.

The characteristic part of this embodiment is that the resist layer 42 is overlaid on the interconnection layer 35 through the insulation protection layer 41, and the lower edge portion 42a1 of the hole formation surface 42a of the resist layer 42 is disposed on the insulation protection layer 41 so that the resist layer 42 does not extend to the exposed surface 35b of the interconnection layer 35.

As shown in Fig. 2, the surface 42a of the resist layer 42 overall has a shape closer to a planarized surface than the surface 41a of the insulation protection layer 41. However, for example, when the resist layer 42 is not overlapped on the interconnection layer 35 and is disposed away in the planar direction from the interconnection layer 35, a sharp level difference occurs between the resist layer 42 and the interconnection layer 35. As a result, the electrode layers 15, 16, 18, and 19 and the lead layer 17 which are formed over from the resist layer 42 to the exposed surface 35b of the interconnection layer 35 are easily disconnected.

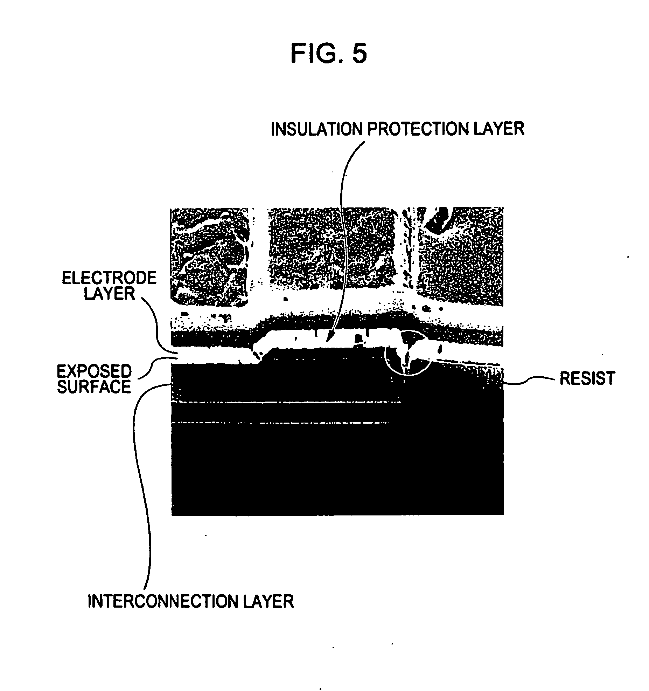

Fig. 5 is a FIB photograph showing a cross-sectional shape in the case where the resist layer 42 is not overlapped on the interconnection layer 35 and is disposed away in the planar direction from the interconnection layer 35. As shown in Fig. 5, in the electrode layer formed so as to extend over from the resist layer 42 to the insulation protection layer 41 and the exposed surface 35b of the interconnection layer 35, a disconnection occurs due to the sharp level difference at the portion indicated by a circle in Fig. 5.

Accordingly, as shown in Fig. 3, by forming the resist layer 42 so as to extend over the interconnection layer 35 excluding the hole portion 44, the entire formation surface for the electrode layers 15, 16, 18, and 19 and the lead layer 17 can be formed to be a smooth surface with small steps, and thus the electrode layers 15, 16, 18, and 19 and the lead layer 17 are prevented from being disconnected.

Moreover, in this embodiment, the resist layer 42 does not extend over to the exposed surface 35b of the interconnection layer 35. That is, the resist layer 42 and the interconnection layer 35 are not directly in contact with each other. The adhesiveness between the resist layer 42 and the interconnection layer 35, in particular, the interconnection layer 35 composed of Al, is low, and the resist layer 42 is easily separated from the surface of the interconnection layer 35. Furthermore, the resist layer 42 is particularly easily separated due to heat treatment or the like performed in the process of forming the magnetic detection element 10. On the other hand, the adhesiveness between the insulation protection layer 41 and the interconnection layer 35 and the adhesiveness between the insulation protection layer 41 and the resist layer 42 are substantially higher than the adhesiveness in the case where the resist layer 42 and the interconnection layer 35 are directly bonded to each other as described above. Therefore, in this embodiment, by disposing the lower edge portion 42b1 of the hole formation surface 42b of the resist layer 42 on the insulation protection layer 41 so that the resist layer 42 does not extend over to the exposed surface 35b of the interconnection layer 35, separation of the resist layer 42 from the surface of the interconnection layer 35 can be appropriately prevented. Consequently, cracks and disconnections due to the layer separation do not occur in the electrode layers 15, 16, 18, and 19 and the lead layer 17 formed on the resist layer 42. Furthermore, when the layer separation occurs, the separated portion is in contact with an external environment, which may easily result in corrosion or the like of the detection circuit. However, in this embodiment, the detection circuit can be appropriately sealed by the insulation layer 40. For the reasons described above, in this embodiment, it is possible to obtain a magnetic detection device 1 having stable characteristics.

Furthermore, the lower edge portion 42b1 of the hole formation surface 42b of the resist layer 42 may be in the same position as the lower edge portion 41b1 of the hole formation surface 41b of the insulation protection layer 41. The expression "on the insulation protection layer 41" includes "on the lower edge portion 41b1 of the insulation protection layer 41". However, by disposing the lower edge portion 42b1 of the resist layer 42 more away from the exposed surface 35b of the interconnection layer 35 than the lower edge portion 41b of the insulation protection layer 41, the entire resist layer 42 can be overlaid only on the insulation protection layer 41, and separation of the resist layer 42 from the surface of the interconnection layer 35 can be appropriately prevented.

Furthermore, in this embodiment, by forming the magnetic detection element 10 on the resist layer 42 the surface of which is closer to a planarized surface than the insulation protection layer 41, a magnetic detection element 10 having the multilayer structure can be formed with high precision, and the magnetic detection element 10 having stable characteristics can be produced.

Furthermore, since the interconnection layer 35 of the detection circuit and the lead layer 17 are disposed so as to overlap each other and conductively connected to each other vertically, the device can be configured in a small area compared with the case where the interconnection layer 35 and the lead layer 17 are disposed in a plane, which is preferable.

As shown in Fig. 3, the hole formation surface 41b of the insulation protection layer 41 is an inclined surface which is inclined such that the size of the hole portion 44 (planar area of the hole) gradually increases from the lower surface side toward the upper surface side (i.e., in the Z1 direction shown in Fig. 3). Similarly, the hole formation surface 42b of the resist layer 42 is an inclined surface which is inclined such that the size of the hole portion 44 gradually increases from the lower surface side toward the upper surface side (i.e., in the Z1 direction shown in Fig. 3). In the cross section taken in the thickness direction as shown in Fig. 3, the inclined surface may have a linear shape or a curved shape. The curved shape may be a convex shape in which the hole formation surfaces 41b and 42b protrude or a concave shape in which the hole formation surfaces 41b and 42b are recessed. Preferably, the angle θ1 between the hole formation surface 41b (in the case where the cross section of the hole formation surface has a curved shape, a tangent at a point (point of tangency) where a line passing through the center in the thickness direction of the insulation protection layer 41 and the hole formation surface intersect with each other, refer to the hole formation surface 42b below) and the lower surface of the insulation protection layer 41 and the angle θ2 between the hole formation surface 42b (in the case where the cross section of the hole formation surface has a curved shape, a tangent T at a point (point of tangency) P where the line L passing through the center in the thickness direction of the resist layer 42 and the hole formation surface 42b intersect with each other) and the lower surface of the insulation protection layer 41 are each about 45°.

Since the hole formation surface 42b of the resist layer 42 and the hole formation surface 41b of the insulation protection layer 41 are formed into the included surfaces as described above, the surface extending from the hole formation surface 41b and the hole formation surface 42b to the exposed surface 35b of the interconnection layer 35 can be formed into a gently inclined surface. Consequently, the electrode layers 15, 16, 18, and 19 and the lead layer 17 can be formed on the hole formation surface 42b of the resist layer 42 and the hole formation surface 41b of the insulation protection layer 41 with predetermined thicknesses without disconnections, etc.

In the embodiment shown in Fig. 3, the hole formation surface 42b of the resist layer 42 and the hole formation surface 41b of the insulation protection layer 41 are formed into continuously inclined surfaces without steps. Such a shape can be formed by the manufacturing method described below. Thereby, more effectively, the electrode layers 15, 16, 18, and 19 and the lead layer 17 can be appropriately formed without disconnections, etc. with predetermined thicknesses.

As shown in Fig. 3, the insulating coating layer 43 is formed only on the resist layer 42. However, the insulating coating layer 43 may extend over the hole formation surface 41b of the insulation protection layer 41, or may extend over a part of the exposed surface 35 so as not to cover the entire exposed surface 35b of the interconnection layer 35.

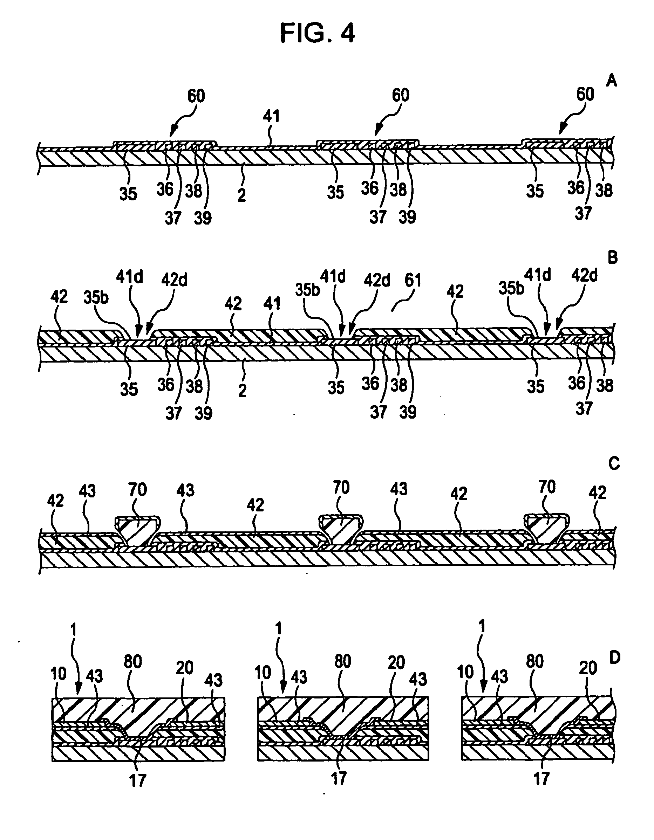

A method of manufacturing the magnetic detection device 1 according to this embodiment will be described with reference to Fig. 4. In the step shown in Fig. 4A, a plurality of detection circuits, each including an interconnection layer 35, active elements 36 to 38, a resistor 39, etc., are formed on a substrate 2. The detection circuits 60 are formed by thin-film forming processes, such as a CVD process, a sputtering process, and a plating process.

Next, an insulation protection layer (passivation film) 41 composed of silicon nitride (SiN) or the like is formed by sputtering or a CVD process over each detection circuit 60 and the substrate 2. In Fig. 4, the surface 41a of the insulation protection layer 41 on the detection circuit 60 is shown as a flat surface. However, this is just a simplification and does not mean that a stepped shape is not formed. As in Fig. 2, the surface 41a of the insulation protection layer 41 formed on the detection circuit 60 has a stepped shape.

Next, in the step shown in Fig. 4B, a resist layer 42 is formed over the entire surface of the insulation protection layer 41, for example, by screen printing or the like, and a hole portion 42d is formed precisely at a position facing a part of the upper surface of each interconnection layer 35 in the thickness direction by exposure and development of the resist layer 42. The exposed insulation protection layer 41 in the hole portion 42d is removed by etching. In this step, a part of the interconnection layer 35 may also be removed, and the exposed surface 35b of the interconnection layer 35 may have a slightly recessed shape.

As shown in Fig. 4B, by removing the insulation protection layer 41 by etching, a hole portion 41d is formed in the insulation protection layer 41, and a part of the upper surface of the interconnection layer 35 is exposed as an exposed surface 35b.

The resist layer 42 is then thermally cured. In this embodiment, before the resist layer 42 is thermally cured, preferably, a predetermined heat treatment is performed to sag the hole formation surface 42b of the resist layer 42, thereby forming the inclined surface shape shown in Fig. 3.

For example, the resist layer 42 is subjected to a post-baking process at 130°C for 10 minutes, and then is thermally cured, for example, in a nitrogen atmosphere at 300°C for 60 minutes.

In the step shown in Fig. 4B, by performing the heat treatment on the resist layer 42, the hole formation surface 42b of the resist layer 42 is sagged and an inclined surface as shown in Fig. 3 is formed. By forming the hole forming surface 42b of the resist layer 42 into an inclined surface as described above, when the insulation protection layer 41 exposed at the hole portion 42d of the resist layer 42 is removed by etching, the etching follows the shape of the inclined surface, and the hole forming surface 41b in the insulation protection layer 41 is also formed into an inclined surface as shown in Fig. 3.

According to the manufacturing method described above, the resist layer 42 can be appropriately formed so as to extend over the interconnection layer 35. As shown in Fig. 3, the hole formation surface 42b of the resist layer 42 and the hole formation surface 41b of the insulation protection layer 41 can be formed into inclined surfaces, and the hole formation surfaces 41b and 42b can be formed into a continuous surface. Furthermore, the lower edge portion 42b of the hole formation surface 42b of the resist layer 42 can be formed on the insulation protection layer 41 more away from the exposed surface 35b of the interconnection layer 35 than the lower edge portion 41b1 of the hole formation surface 41b of the insulation protection layer 41 (refer to Fig. 3).

In the step shown in Fig. 4B, the resist layer 42 and the insulation protection layer 41 having predetermined shapes can be easily formed, which is preferable. In particular, in the manufacturing method described above, by etching the insulation protection layer 41 exposed at the hole portion 42d formed in the resist layer 42, using the resist layer 42 as a mask, the hole portion 41d can also be formed easily in the insulation protection layer 41.

However, formation of the resist layer 42 and formation of the hole portion 41d in the resist layer 42 may be performed after forming the hole portion 41d in the insulating protection 41 first.

In the manufacturing method described above, the upper surface 35a of the interconnection layer 35 is easily affected by etching. In order to prevent the upper surface 35a of the interconnection layer 35 from being affected by etching, before the insulation protection layer 41 is formed by sputtering in the step shown in Fig. 4A, a resist layer for lift-off is formed on a portion of the interconnection layer 35, the insulation protection layer 41 is formed by sputtering on the detection circuit 60 and the substrate 2 not covered with the resist layer for lift-off, and then, the resist layer for lift-off is removed. Subsequently, formation of the resist layer 42 and formation of the hole portion 41d in the resist layer 42 are performed.

In the step shown in Fig. 4C, a resist layer 70 for lift-off is formed in the hole portions 41d and 42d formed in the insulation protection layer 41 and the resist layer 42, and an insulating coating layer 43 composed of Al₂O₃ or the like is formed by sputtering or the like on the resist layer 42. In this step, the same material layer as the insulating coating layer 43 adheres to the resist layer 70 for lift-off. Then, the resist layer 70 for lift-off is removed.

Then, the magnetic detection element 10 and the fixed resistance element 20 are formed on the insulating coating layer 43, and the electrode layers 15, 16, 18, and 19 and the lead layer 17 are formed. In this step, the lead layer 17 and the electrode layers 18 and 19 are extended to the exposed surface 35b of the interconnection layer 35. Thereby, the interconnection layer 35 and the magnetic detection element 10 are electrically connected to each other and the interconnection layer 35 and the fixed resistance element 20 are electrically connected to each other.

The electrode layers 15, 16, 18, and 19 and the lead layer 17 can be formed by sputtering, plating, or the like using a nonmagnetic conductive material.

Next, in the step shown in Fig. 4D, the magnetic detection elements 10 and the fixed resistance elements 20 are molded with a resin 80 to form packages, and then each magnetic detection device 1 is separated by dicing. Alternatively, packaging may be performed after each magnetic detection device 1 is separated by dicing before molding with the resin 80.

In this embodiment, by applying the resist layer 42 onto the insulation protection layer 41, it is possible to obtain an insulating surface that is closer to a planarized surface than the surface of the insulation protection layer 41. Consequently, the magnetic detection element 10 and the fixed resistance element 20 can be formed on the insulating surface that is closer to the planarized surface. Moreover, in the manufacturing method according to this embodiment, the resist layer 42 can be formed so as to appropriately extend over the interconnection layer 25. As shown in Fig. 3, the hole formation surface 42b of the resist layer 42 and the hole formation surface 41b of the insulation protection layer 41 can be formed into a continuous surface. The lower edge portion 42b of the hole formation surface 42b of the resist layer 42 can be disposed on the insulation protection layer 41 more away from the exposed surface 35b of the interconnection layer 35 than the lower edge portion 42b1 of the hole formation surface 41b of the insulation protection layer 41. Consequently, the formation surface for the electrode layers 15, 16, 18, and 19 and the lead layer 17 is formed as a gently inclined surface, and the resist layer 42 and the interconnection layer 35 are not directly in contact with each other. Therefore, separation of the resist layer 42 from the interconnection layer 35 does not occur even if heat treatment is performed in the process of forming the magnetic detection element 10 or the like, and the electrode layers 15, 16, 18, and 19 and the lead layer 17 can be formed appropriately without disconnections. Thus, it is possible to improve electrical stability between the magnetic detection element 10 and the interconnection layer 35 and between the fixed resistance element 20 and the interconnection layer 35.

In this embodiment, the insulating layer 40 has a three-layered structure. However, the insulating layer 40 may have a two-layered structure including the insulation protection layer 41 and the resist layer 42, or a four or more layered structure.

Furthermore, in this embodiment, one magnetic detection element 10 and one fixed resistance element 20 are provided. However, in the case where two magnetic detection elements and two fixed resistance elements 20 are provided to constitute a bridge circuit, a magnetic detection device having higher magnetic sensitivity can be produced, which is preferable.

In the embodiment described above, the magnetic detection element 10 and the fixed resistance element 20 are combined together. However, other configurations may be employed. Examples include a configuration in which magnetic detection elements having different Pin directions constitute a circuit, and a circuit including a combination of a first magnetic detection element and a second magnetic detection element in which the resistance of the first magnetic detection element varies when the N pole of a magnet approaches and does not vary when the S pole approaches, and the resistance of the second magnetic detection element varies when the S pole of a magnet approaches and does not vary when the N pole approaches. Brief Description of Drawings
[Fig. 1] Fig. 1 is a perspective view showing a magnetic detection device according to an embodiment.
[Fig. 2] Fig. 2 is a longitudinal cross-sectional view of a magnetic detection device according to a first embodiment, taken along the line II-II of Fig. 1.
[Fig. 3] Fig. 3 is an enlarged longitudinal cross-sectional view showing a part of Fig. 2.
[Fig. 4] Fig. 4 is a process chart showing manufacturing steps of a magnetic detection device according to the embodiment (each drawing being the same longitudinal cross-sectional view as Fig. 2).
[Fig. 5] Fig. 5 is a FIB photograph showing a cross section of a magnetic detection device in which a resist layer is not overlapped on an interconnection layer. Reference Numerals

- 1: magnetic detection device
- 2: substrate
- 15, 16, 18, 19: electrode layer
- 17: lead layer
- 10: magnetic detection element
- 20: fixed resistance element
- 35: interconnection layer
- 35b: exposed surface
- 36 to 38: active element
- 39: resistor
- 40: insulating layer
- 41: insulation protection layer (passivation film)
- 42: resist layer
- 42b, 43b: hole formation surface
- 42b1, 43b1: lower edge portion
- 43: insulating coating layer
- 44: hole
- 60: detection circuit
- 70: resist layer for lift-off
- 80: resin

## Claims

1. A magnetic detection device (1) comprising:
a magnetic detection element (10) using a magnetoresistance effect in which an electrical resistance varies in response to an external magnetic field; and
a detection circuit (60) which detects a variation in the electrical resistance of the magnetic detection element (10),
wherein the detection circuit (60) having an interconnection layer (35) is disposed on a substrate (2), and the detection circuit (60) and the substrate (2) are covered with an insulating layer (40),
wherein the insulating layer (40) includes an insulation protection layer (41) extending over from the detection circuit (60) to the substrate (2) and having a hole (44) extending from a portion of the interconnection layer (35), and a resist layer (42) overlapping the insulation protection layer (41) and having a hole (44) at a position facing the hole (44) formed in the insulation protection layer (41) in a layer thickness direction, thereby eliminating a step on the surface of the insulation protection layer (41) resulting from the level difference between the substrate (2) and the detection circuit (60),
wherein the resist layer (42) extends onto the interconnection layer (35) through the insulation protection layer (41) and a lower edge portion (42b1) of a hole formation surface (42b) of the resist layer (42) is disposed on the insulation protection layer (41) so that the resist layer (42) is not directly in contact with an upper surface of the interconnection layer (35),
wherein the magnetic detection element (10) is disposed on the surface of the insulating layer (40), a conductive connection layer connected to the magnetic detection element (10) passes through the hole (44) and extends to an exposed surface (35b) of the interconnection layer (35), and the magnetic detection element (10) and the interconnection layer (35) are conductively connected to each other through the connection layer wherein the hole formation surface (42b) of the resist layer (42) is an inclined surface which is inclined such that the size of the hole (44) gradually increases from a lower surface side toward an upper surface side wherein a hole formation surface (41b) of the insulation protection layer (41) is an inclined surface which is inclined such that the size of the hole (44) gradually increases from a lower surface side toward an upper surface side,
**characterized in that**
the insulating protection layer (41) overlaps part of the interconnection layer (35);
the hole formation surface (42b) of the resist layer (42) and the hole formation surface (41b) of the insulation protection layer (41) are formed into continuously inclined surfaces without steps;
a lead layer (17) connected to the magnetic detection element (10) is overlapped and in contact with the exposed surface of the interconnection layer (35b) and the hole formation surfaces (41b, 42b) of the resist layer (42) and the insulation protection layer (41); and
a thickness of the lead layer (17) is smaller than a hole depth.

2. The magnetic detection device (1) according to Claim 1, wherein the insulation protection layer (41) is composed of any one of SiN, SiO₂, Al₂O₃, TEOS, and Ta₂O₅, or a layered structure including any two or more of them.

3. The magnetic detection device (1) according to Claim 2, wherein the insulation protection layer (41) is composed of SiN.

4. The magnetic detection device (1) according to any one of Claims 1 to 3, wherein the interconnection layer (35) is composed of any one of Al, Cu, Al-Si, Al-Si-Cu, Cr, Ta, W, Au, Ag-Pd, and Ag-Pt-Pd, or a layered structure including any two or more of them.

5. The magnetic detection device (1) according to Claim 4, wherein the interconnection layer (35) is composed of Al.

6. The magnetic detection device (1) according to any one of Claims 1 to 5, wherein a fixed resistance element which is connected in series to the magnetic detection element (10) and in which an electrical resistance does not vary in response to an external magnetic field is disposed on a surface of the insulating layer (40), and a connection layer provided between the magnetic detection element (10) and the fixed resistance element is conductively connected to the interconnection layer (35) through the hole (44), wherein
the magnetic detection element (10) has a stack structure of a first fixed magnetic layer, a non-magnetic layer and a free magnetic layer stacked in that order,
the fixed resistant element (20) has another stack structure of a second fixed magnetic layer, a third fixed magnetic layer and a non-magnetic layer stacked in that order,
the first, second and third fixed magnetic layer each have a fixed magnetization, and
the free magnetic layer and the second fixed layer are made of the same material.

7. The magnetic detection device (1) according to Claim 6, wherein the fixed resistance element is composed of the same material layer as the magnetic detection element (10).

8. A method of manufacturing a magnetic detection device (1) including a magnetic detection element (10) using a magnetoresistance effect in which an electrical resistance varies in response to an external magnetic field, and a detection circuit (60) which detects a variation in the electrical resistance of the magnetic detection element (10), the method comprising the steps of:
(a) forming the detection circuit (60) on a substrate (2);
(b) forming an insulation protection layer (41) by sputtering or chemical vapor deposition so as to extend over from the detection circuit (60) to the substrate (2), and forming a hole (44) in the insulation protection layer (41) so that a portion of an interconnection layer (35) constituting the detection circuit (60) is exposed;
(c) applying a resist layer (42) onto the insulation protection layer (41) so as to at least reduce the level difference between the substrate (2) and the detection circuit (60) covered with the insulation protection layer (41), forming a hole (44) in the resist layer (42), the hole (44) overlying the hole (44) formed in the insulation protection layer (41) in a layer thickness direction on the interconnection layer (35), and disposing a lower edge portion (42b1) of a hole formation surface (42b) of the resist layer (42) on the insulation protection layer (41) so that the resist layer (42) is not directly in contact with an upper surface of the interconnection layer (35); and
(d) forming the magnetic detection element (10) on the insulating surface, forming a conductive connection layer connected to the magnetic detection element (10) so as to extend through the hole (44) to an exposed surface (35b) of the interconnecting layer, and conductively connecting the magnetic detection element (10) and the interconnection layer (35) to each other through the connection layer, wherein, in the step (b), a hole formation surface (41 b) of the insulation protection layer (41) is formed into an inclined surface so that the size of the hole (44) gradually increases from a lower surface side toward an upper surface side, and in the step (c), a hole formation surface (42b) of the resist layer (42) is formed into an inclined surface so that the size of the hole (44) gradually increases from a lower surface side toward an upper surface side,
**characterized in that**
the insulating protection layer (41) is formed overlapping part of the interconnection layer (35);
the hole formation surface (42b) of the resist layer (42) and the hole formation surface (41b) of the insulation protection layer (41) are formed into continuously inclined surfaces without steps;
a lead layer (17) connected to the magnetic detection element (10) is overlapped and in contact with the exposed surface of the interconnection layer (35b) and the hole formation surfaces (41 b, 42b) of the resist layer (42) and the insulation protection layer (41); and
the lead layer (17) is formed having a thickness that is smaller than a hole depth.

9. The method of manufacturing the magnetic detection device (1) according to Claim 8, wherein the resist layer (42) is subjected to heat treatment to form the inclined surface before the resist layer (42) is thermally cured.

10. The method of manufacturing the magnetic detection device (1) according to any one of Claims 8 or 9, wherein, without forming a hole (44) in the insulation protection layer (41) in the step (b), using the resist layer (42) formed in the step (c) as a mask, the insulation protection layer (41) exposed at the hole (44) of the resist layer (42) is removed, thereby forming a hole (44) in the insulation protection layer (41) in which an upper surface of the interconnection layer (35) is exposed.

11. The method of manufacturing the magnetic detection device (1) according to any one of Claims 8 to 10, further comprising, between the step (c) and the step (d), the step of (e) forming an inorganic insulating layer (40), as an underlying film of the magnetic detection element (10), on the resist layer (42).

## Patentansprüche

1. Magneterkennungsvorrichtung (1) mit
einem Magneterkennungselement (10), das den Magnetwiderstandseffekt benutzt, bei dem sich ein elektrischer Widerstand in Reaktion auf ein äußeres magnetisches Feld verändert; und
einer Erkennungsschaltung (60), die eine Veränderung des elektrischen Widerstandes des Magneterkennungselements (10) erkennt,
wobei die Erkennungsschaltung (60), die eine Verbindungsschicht (35) hat, auf einem Substrat (2) angeordnet ist, und die Erkennungsschaltung (60) und das Substrat (2) von einer isolierenden Schicht (40) bedeckt sind,
wobei die isolierende Schicht (40) eine Isolationsschutzschicht (41), die sich von der Erkennungsschaltung (60) bis über das Substrat (2) erstreckt und die eine Öffnung (44) hat, die sich von einem Bereich der Verbindungsschicht (35) ausgehend erstreckt, und eine Widerstandsschicht (42) aufweist, die mit der Isolationsschutzschicht (41) überlappt und an einer Stelle, die der Öffnung (44), die in Richtung der Dicke der Schicht in der Isolationsschutzschicht (41) ausgebildet ist, gegenüberliegt, eine Öffnung (44) hat, wodurch sie eine Stufe auf der Oberfläche der Isolationsschutzschicht (41) beseitigt, die sich aus dem Niveauunterschied zwischen dem Substrat (2) und der Erkennungsschaltung (60) ergibt,
wobei sich die Widerstandsschicht (42) durch die Isolationsschutzschicht (41) hindurch auf die Verbindungsschicht (35) erstreckt, und ein unterer Randbereich (42b1) einer Öffnungsausbildungsfläche (42b) der Widerstandsschicht (42) so auf der Isolationsschutzschicht (41) angeordnet ist, dass die Widerstandsschicht (42) nicht direkt im Kontakt mit einer oberen Fläche der Verbindungsschicht (35) ist,
wobei das Magneterkennungselement (10) auf der Fläche der Isolationsschicht (40) angeordnet ist, eine leitende Verbindungsschicht, die mit dem Magneterkennungselement (10) verbunden ist, durch die Öffnung (44) verläuft und sich zu einer freiliegenden Fläche (35b) der Verbindungsschicht (35) erstreckt, und das Magneterkennungselement (10) und die Verbindungsschicht (35) durch die Verbindungsschicht leitend miteinander verbunden sind, wobei die Öffnungsausbildungsfläche (42b) der Widerstandsschicht (42) eine geneigte Fläche ist, die so geneigt ist, dass die Größe der Öffnung (44) von einem unteren Bereich der Fläche zu einem oberen Bereich der Fläche graduell zunimmt, wobei eine Öffnungsausbildungsfläche (41b) der Isolationsschutzschicht (41) eine geneigte Fläche ist, die so geneigt ist, dass die Größe der Öffnung (44) von einem unteren Bereich der Fläche zu einem oberen Bereich der Fläche graduell zunimmt,
**dadurch gekennzeichnet, dass**
die Isolationsschutzschicht (41) einen Teil der Verbindungsschicht (35) überlappt;
die Öffnungsausbildungsfläche (42b) der Widerstandsschicht (42) und die Öffnungsausbildungsfläche (41b) der Isolationsschutzschicht (41) als kontinuierlich geneigte Flächen ohne Stufen ausgebildet sind;
eine Leiterschicht (17), die mit dem Magneterkennungselement (10) verbunden ist, die freiliegende Fläche der Verbindungsschicht (35b) und die Öffnungsausbildungsflächen (41b, 42b) der Widerstandsschicht (42) und der Isolationsschutzschicht (41) überlappt und mit ihnen im Kontakt ist; und
eine Dicke der Leiterschicht (17) kleiner als eine Lochtiefe ist.

2. Magneterkennungsvorrichtung (1) nach Anspruch 1, wobei die Isolationsschutzschicht (41b) aus einem beliebigen von SiN, SiO₂, Al₂O₃, TEOS und Ta₂O₅ oder einer Schichtstruktur, die wenigstens zwei beliebige davon enthält, zusammengesetzt ist.

3. Magneterkennungsvorrichtung (1) nach Anspruch 2, wobei die Isolationsschutzschicht (41) aus SiN zusammengesetzt ist.

4. Magneterkennungsvorrichtung (1) nach einem der Ansprüche 1 bis 3, wobei die Verbindungsschicht (35) aus einem beliebigen von Al, Cu, Al-Si, Al-Si-Cu, Cr, Ta, W, Au, Ag-Pd und Ag-Pt-Pd oder einer Schichtstruktur, die wenigstens zwei davon enthält, zusammengesetzt ist.

5. Magneterkennungsvorrichtung (1) nach Anspruch 4, wobei die Verbindungsschicht (35) aus Al zusammengesetzt ist.

6. Magneterkennungsvorrichtung (1) nach einem der Ansprüche 1 bis 5, wobei ein Festwiderstandselement, das in Reihe mit dem Magneterkennungselement (10) verbunden ist und in dem sich der elektrische Widerstand in Reaktion auf ein äußeres magnetisches Feld nicht ändert, auf einer Fläche der isolierenden Schicht (40) angeordnet ist, und eine Verbindungsschicht, die zwischen dem Magneterkennungselement (10) und dem Festwiderstandselement vorgesehen ist, durch die Öffnung (44) leitend mit der Verbindungsschicht (35) verbunden ist, wobei
das Magneterkennungselement (10) eine Schichtstruktur aus einer ersten festen magnetischen Schicht, einer nicht magnetischen Schicht und einer freien magnetischen Schicht, die in dieser Reihenfolge aufgeschichtet sind, hat,
das Festwiderstandselement (20) eine andere Schichtstruktur aus einer zweiten festen magnetischen Schicht, einer dritten festen magnetischen Schicht und einer nicht magnetischen Schicht hat, die in dieser Reihenfolge geschichtet sind,
die erste, die zweite und die dritte feste magnetische Schicht jeweils eine feste Magnetisierung haben, und
die freie magnetische Schicht und die zweite feste Schicht aus dem gleichen Material gemacht sind.

7. Magneterkennungsvorrichtung (1) nach Anspruch 6, wobei das Festwiderstandselement aus dem gleichen Material wie das Magneterkennungselement (10) zusammengesetzt ist.

8. Verfahren des Herstellens einer Magneterkennungsvorrichtung (1) mit einem Magneterkennungselement (10), das einen Magnetwiderstandseffekt benutzt, bei dem sich ein elektrischer Widerstand in Reaktion auf ein äußeres magnetisches Feld ändert, und einer Erkennungsschaltung (60), die eine Veränderung des elektrischen Widerstandes des Magneterkennungselementes (10) erkennt, wobei das Verfahren die Schritte aufweist:
(a) Ausbilden der Erkennungsschaltung (60) auf einem Substrat (2);
(b) Ausbilden einer Isolationsschutzschicht (41) durch Sputtern oder chemische Dampfabscheidung (CVD), so dass sie sich von der Erkennungsschaltung (60) bis über das Substrat (2) erstreckt, und Ausbilden einer Öffnung (44) in der Isolationsschutzschicht (41), so dass ein Bereich der Verbindungsschicht (35), der die Erkennungsschaltung (60) bildet, freigelegt ist;
(c) Aufbringen einer Widerstandsschicht (42) auf die Isolationsschutzschicht (41), um so den Niveauunterschied zwischen dem Substrat (2) und der Erkennungsschaltung (60), die mit der Isolationsschutzschicht (41) bedeckt ist, wenigstens zu reduzieren, Ausbilden einer Öffnung (44) in der Widerstandsschicht (42), wobei die Öffnung (44) über der Öffnung (44) liegt, die in der Isolationsschutzschicht (41) in Richtung der Dicke der Schicht auf der Verbindungsschicht (35) ausgebildet ist, und Anordnen eines unteren Randbereiches (42b1) einer Öffnungsausbildungsfläche (42b) der Widerstandsschicht (42) auf der Isolationsschutzschicht (41), so dass die Widerstandsschicht (42) nicht im direkten Kontakt mit einer oberen Fläche der Verbindungsschicht (35) ist; und
(d) Ausbilden des Magneterkennungselementes (10) auf der isolierenden Fläche, Ausbilden einer leitenden Verbindungsschicht, die mit dem Magneterkennungselement (10) verbunden ist, so dass sie sich durch die Öffnung (44) zu einer freiliegenden Fläche (35b) der Verbindungsschicht erstreckt, und leitendes Verbinden des Magneterkennungselementes (10) und der Verbindungsschicht (35) miteinander durch die Verbindungsschicht, wobei im Schritt (b) eine Öffnungsausbildungsfläche (41b) der Isolationsschutzschicht (41) als eine geneigte Oberfläche ausgebildet ist, so dass die Größe der Öffnung (44) von einem unteren Bereich der Fläche zu einem oberen Bereich der Fläche graduell zunimmt und im Schritt (c) eine Öffnungsausbildungsfläche (42b) der Widerstandsschicht auf der geneigten Fläche so ausgebildet wird, dass die Größe der Öffnung (44) von einem unteren Bereich zu einem oberen Bereich graduell zunimmt,
**dadurch gekennzeichnet, dass**
die Isolationsschutzschicht (41) so ausgebildet ist, dass sie einen Bereich der Verbindungsschicht (35) überlappt;
die Öffnungsausbildungsfläche (42b) der Widerstandsschicht (42) und die Öffnungsausbildungsfläche (41b) der Isolationsschutzschicht (41) als kontinuierlich geneigte Flächen ohne Stufen ausgebildet sind;
eine Leiterschicht (17), die mit dem Magneterkennungselement (10) verbunden ist, im Kontakt mit der freigelegten Fläche der Verbindungsschicht (35b) und den Öffnungsausbildungsflächen (41b, 42b) der Widerstandsschicht (42) und der Isolationsschutzschicht (41) ist, und diese überlappt; und
die Leiterschicht (17) mit einer Dicke ausgebildet ist, die kleiner als eine Lochtiefe ist.

9. Verfahren des Herstellens der Magneterkennungsvorrichtung (1) nach Anspruch 8, wobei die Widerstandsschicht (42) einer Wärmebehandlung ausgesetzt wird, um die geneigte Fläche auszubilden, bevor die Widerstandsschicht (42) thermisch ausgehärtet wird.

10. Verfahren des Herstellens der Magneterkennungsvorrichtung (1) nach einem der Ansprüche 8 oder 9, wobei die Isolationsschutzschicht (41), die an der Öffnung (44) der Widerstandsschicht (42) freigelegt ist, entfernt wird, ohne im Schritt (b) eine Öffnung (44) in der Isolationsschutzschicht (41) auszubilden, wodurch eine Öffnung (44) in der Isolationsschutzschicht (41) ausgebildet wird, in der eine obere Fläche der Verbindungsschicht (35) freigelegt ist, wobei die Widerstandsschicht (42), die im Schritt (c) ausgebildet worden ist, als Maske benutzt wird.

11. Verfahren des Herstellens der Magneterkennungsvorrichtung (1) nach einem der Ansprüche 8 bis 10, zwischen den Schritten (c) und (d) zusätzlich aufweisend den Schritt (e) des Ausformens einer anorganischen Isolationsschicht (40) auf der Widerstandsschicht (42) als eine dem Magneterkennungselemente (10) unterliegende Schicht.

## Revendications

1. Dispositif de détection magnétique (1) comprenant :
un élément de détection magnétique (10) utilisant un effet de magnétorésistance dans lequel une résistance électrique varie en réponse à un champ magnétique extérieur ; et
un circuit de détection (60) qui détecte une variation de la résistance électrique de l'élément de détection magnétique (10),
dans lequel le circuit de détection (60) ayant une couche d'interconnexion (35) est disposé sur un substrat (2), et le circuit de détection (60) et le substrat (2) sont couverts d'une couche isolante (40),
dans lequel la couche isolante (40) comprend une couche de protection d'isolant (41) s'étendant sur le circuit de détection (60) jusqu'au substrat (2) et comportant un trou (44) s'étendant depuis une partie de la couche d'interconnexion (35), et une couche de réserve (42) chevauchant la couche de protection d'isolant (41) et comportant un trou (44) en une position faisant face au trou (44) formé dans la couche de protection d'isolant (41) dans une direction d'épaisseur de couche, éliminant ainsi un épaulement à la surface de la couche de protection d'isolant (41) résultant de la différence de niveau entre le substrat (2) et le circuit de détection (60),
dans lequel la couche de réserve (42) s'étend sur la couche d'interconnexion (35) à travers la couche de protection d'isolant (41) et une partie de bord inférieur (42b1) d'une surface de formation de trou (42b) de la couche de réserve (42) est disposée sur la couche de protection d'isolant (41) de telle manière que la couche de réserve (42) n'est pas directement en contact avec une surface supérieure de la couche d'interconnexion (35),
dans lequel l'élément de détection magnétique (10) est placé sur la surface de la couche isolante (40), une couche de connexion conductrice connectée à l'élément de détection magnétique (10) passe dans le trou (44) et s'étend jusqu'à une surface exposée (35b) de la couche d'interconnexion (35), et l'élément de détection magnétique (10) et la couche d'interconnexion (35) sont connectés de façon conductrice l'un à l'autre à travers la couche de connexion, dans lequel la surface de formation de trou (42b) de la couche de réserve (42) est une surface inclinée qui est inclinée de telle manière que la taille du trou (44) augmente progressivement du côté d'une surface inférieure vers un côté de surface supérieure, dans lequel une surface de formation de trou (41b) de la couche de protection d'isolant (41) est une surface inclinée qui est inclinée de telle manière que la taille du trou (44) augmente progressivement d'un côté de surface inférieure vers un côté de surface supérieure,
**caractérisé en ce que** :
la couche de protection d'isolant (41) recouvre une partie de la couche d'interconnexion (35) ;
la surface de formation de trou (42b) de la couche de réserve (42) et la surface de formation de trou (41b) de la couche de protection d'isolant (41) ont la forme de surfaces inclinées de façon continue sans épaulements ;
une couche d'entrée (17) connectée à l'élément de détection magnétique (10) est en chevauchement et en contact avec la surface exposée de la couche d'interconnexion (35b) et les surfaces de formation de trou (41b, 42b) de la couche de réserve (42) et de la couche de protection d'isolant (41) ; et
une épaisseur de la couche d'entrée (17) est inférieure à la profondeur d'un trou.

2. Dispositif de détection magnétique (1) selon la revendication 1, dans lequel la couche de protection d'isolant (41) est constituée d'un composé quelconque parmi SiN, SiO₂, Al₂O₃, TEOS et Ta₂O₅, ou d'une structure stratifiée comprenant deux ou plus de ces composés.

3. Dispositif de détection magnétique (1) selon la revendication 2, dans lequel la couche de protection d'isolant (41) est constituée de SiN.

4. Dispositif de détection magnétique (1) selon l'une quelconque des revendications 1 à 3, dans lequel la couche d'interconnexion (35) est constituée d'un élément quelconque parmi Al, Cu, Al-Si, Al-Si-Cu, Cr, Ta, W, Au, Ag-Pd et Ag-Pt-Pd, ou d'une structure stratifiée comprenant deux ou plus de ces éléments.

5. Dispositif de détection magnétique (1) selon la revendication 4, dans lequel la couche d'interconnexion (35) est constituée d'aluminium.

6. Dispositif de détection magnétique (1) selon l'une quelconque des revendications 1 à 5, dans lequel un élément à résistance fixe qui est connecté en série à l'élément de détection magnétique (10) et dans lequel une résistance électrique ne varie pas en réponse à un champ magnétique extérieur est placé sur une surface de la couche isolante (40), et une couche de connexion placée entre l'élément de détection magnétique (10) et l'élément à résistance fixe est connectée de façon conductrice à la couche d'interconnexion (35) à travers le trou (44), dans lequel
l'élément de détection magnétique (10) présente une structure empilée constituée d'une première couche magnétique fixe, d'une couche non magnétique et d'une couche magnétique libre empilées dans cet ordre,
l'élément résistant fixe (20) présente une deuxième structure empilée comportant une deuxième couche magnétique fixe, une troisième couche magnétique fixe et une couche non magnétique empilées dans cet ordre,
les première, deuxième et troisième couches magnétiques fixes ont chacune une magnétisation fixe, et
la couche magnétique libre et la deuxième couche fixe sont faites du même matériau.

7. Dispositif de détection magnétique (1) selon la revendication 6, dans lequel l'élément à résistance fixe est composé de la même couche de matériau que l'élément de détection magnétique (10).

8. Procédé de fabrication d'un dispositif de détection magnétique (1) comprenant un élément de détection magnétique (10) utilisant un effet de magnétorésistance dans lequel une résistance électrique varie en réponse à un champ magnétique extérieur, et un circuit de détection (60) qui détecte une variation de la résistance électrique de l'élément de détection magnétique (10), le procédé comprenant les étapes suivantes :
(a) former le circuit de détection (60) sur un substrat (2) ;
(b) former une couche de protection d'isolant (41) par pulvérisation ou par dépôt chimique en phase vapeur de façon à ce qu'elle s'étende du circuit de détection (60) au substrat (2), et former un trou (44) dans la couche de protection d'isolant (41) de telle manière qu'une partie d'une couche d'interconnexion (35) constituant le circuit de détection (60) est exposée ;
(c) appliquer une couche de réserve (42) sur la couche de protection d'isolant (41) de façon à au moins réduire la différence de niveau entre le substrat (2) et le circuit de détection (60) couvert par la couche de protection d'isolant (41), former un trou (44) dans la couche de réserve (42), le trou (44) recouvrant le trou (44) formé dans la couche de protection d'isolant (41) dans une direction d'épaisseur de couche sur la couche d'interconnexion (35), et placer une partie de bord inférieur (42b1) d'une surface de formation de trou (42b) de la couche de réserve (42) sur la couche de protection d'isolant (41), de sorte que la couche de réserve (42) n'est pas directement en contact avec une surface supérieure de la couche d'interconnexion (35) ; et
(d) former l'élément de détection magnétique (10) sur la surface isolante, former une couche de connexion conductrice connectée à l'élément de détection magnétique (10) de façon à ce qu'elle passe dans le trou (44) et s'étende jusqu'à une surface exposée (35b) de la couche d'interconnexion, et connecter de façon conductrice l'élément de détection magnétique (10) et la couche d'interconnexion (35) l'un à l'autre à travers la couche de connexion, dans lequel, dans l'étape (b), une surface de formation de trou (41b) de la couche de protection d'isolant (41) est une surface inclinée qui est inclinée de telle manière que la taille du trou (44) augmente progressivement d'un côté de surface inférieure vers un côté de surface supérieure, et dans l'étape (c), une surface de formation de trou (42b) de la couche de réserve (42) est une surface inclinée qui est inclinée de telle manière que la taille du trou (44) augmente progressivement du côté d'une surface inférieure vers un côté de surface supérieure,
**caractérisé en ce que** :
la couche de protection d'isolant (41) recouvre une partie de la couche d'interconnexion (35) ;
la surface de formation de trou (42b) de la couche de réserve (42) et la surface de formation de trou (41b) de la couche de protection d'isolant (41) ont la forme de surfaces inclinées de façon continue sans épaulements ;
une couche d'entrée (17) connectée à l'élément de détection magnétique (10) est en chevauchement et en contact avec la surface exposée de la couche d'interconnexion (35b) et les surfaces de formation de trou (41b, 42b) de la couche de réserve (42) et de la couche de protection d'isolant (41) ; et
la couche d'entrée (17) est formée en ayant une épaisseur qui est inférieure à la profondeur d'un trou.

9. Procédé de fabrication du dispositif de détection magnétique (1) selon la revendication 8, dans lequel la couche de réserve (42) est soumise à un traitement thermique pour former la surface inclinée avant que la couche de réserve (42) soit durcie thermiquement.

10. Procédé de fabrication du dispositif de détection magnétique (1) selon l'une quelconque des revendications 8 et 9, dans lequel, sans former un trou (44) dans la couche de protection d'isolant (41) à l'étape (b), en utilisant la couche de réserve (42) formée à l'étape (c) comme masque, la couche de protection d'isolant (41) exposée au niveau du trou (44) de la couche de réserve (42) est retirée, formant de ce fait un trou (44) dans la couche de protection d'isolant (41) dans lequel une surface supérieure de la couche d'interconnexion (35) est exposée.

11. Procédé de fabrication du dispositif de détection magnétique (1) selon l'une quelconque des revendications 8 à 10, comprenant en outre, entre l'étape (c) et l'étape (d), l'étape (e) de formation d'une couche isolante inorganique (40), comme un film sous-jacent de l'élément de détection magnétique (10), sur la couche de réserve (42).
